(19) **Europäisches Patentamt**
**European Patent Office**
**Office européen des brevets**

(11) **EP 3 975 423 A1**

(12) **EUROPEAN PATENT APPLICATION**

(43) Date of publication:
**30.03.2022 Bulletin 2022/13**

(21) Application number: **20198994.4**

(22) Date of filing: **29.09.2020**

(51) International Patent Classification (IPC):
$H03F\ 1/08^{(2006.01)}$      $H03F\ 3/08^{(2006.01)}$
$H03F\ 3/45^{(2006.01)}$      $H03F\ 3/70^{(2006.01)}$
$H03F\ 3/72^{(2006.01)}$      $H03G\ 5/12^{(2006.01)}$
$H03F\ 1/42^{(2006.01)}$

(52) Cooperative Patent Classification (CPC):
**H03F 1/086; H03F 1/42; H03F 3/082;**
**H03F 3/45475; H03F 3/70;** H03F 2200/144;
H03F 2200/36; H03F 2200/45; H03F 2200/54;
H03F 2200/78; H03F 2203/45048;
H03F 2203/45116; H03F 2203/45264;
H03F 2203/45512; H03F 2203/45521;    (Cont.)

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**
Designated Extension States:
**BA ME**
Designated Validation States:
**KH MA MD TN**

(71) Applicant: **ams International AG**
**8645 Jona (CH)**

(72) Inventor: **Michel, Fridolin**
**5656 AE Eindhoven (NL)**

(74) Representative: **Epping - Hermann - Fischer**
**Patentanwaltsgesellschaft mbH**
**Schloßschmidstraße 5**
**80639 München (DE)**

(54) **SHAPER CIRCUIT, PHOTON COUNTING CIRCUIT AND X-RAY APPARATUS**

(57)    In one embodiment a shaper circuit comprises a first amplifier (20) comprising an input (21) and an output (22), the input (21) being configured to receive an input signal (Iin), which comprises one or more current pulses, a feedback component (30) coupled to the output (22) and to the input (21) of the first amplifier (20) thereby forming a feedback loop of the first amplifier (20), and an RC component (40) coupled to the output (22) of the first amplifier (20) and to a reference potential terminal (10). Therein the shaper circuit is configured to provide an output signal (Vout) as a function of the input signal (Iin), the output signal (Vout) comprising one or more voltage pulses, and the RC component (40) is configured to largely cancel a low frequency pole (p1) of the feedback loop of the first amplifier (20).

FIG 1

**(Cont. next page)**

(52) Cooperative Patent Classification (CPC): (Cont.)
 H03F 2203/45526; H03F 2203/45528;
 H03F 2203/45544; H03F 2203/45546;
 H03F 2203/45548; H03F 2203/45598;
 H03F 2203/45601; H03F 2203/45631;
 H03F 2203/45632; H03F 2203/45652;
 H03F 2203/45682; H03F 2203/45684;
 H03F 2203/45691; H03F 2203/45694;
 H03F 2203/45698; H03F 2203/45701;
 H03F 2203/45702; H03F 2203/45712;
 H03F 2203/45716; H03F 2203/45718

**Description**

The present disclosure relates to the field of photon counting. Specifically, the application is directed to a shaper circuit, a photon counting circuit and an X-ray apparatus.

BACKGROUND OF THE INVENTION

In a photon counting system single photon events are detected and counted in order to obtain intensity and spectral information. Whereas a classical image or X-ray sensor just measures the total input intensity, a photon counting system extracts the photon energy, because photons are detected individually. Detection of single photons is enabled by a special sensor material, e.g. CdTe or CdZnTe, which converts quants into current pulses. These current pulses are converted to voltage pulses by a Complementary Metal-oxide semiconductor, CMOS, frontend circuit.

As photon counting detectors are usually deployed in laboratories and hospitals, ultra-low power consumption is typically not an issue. However, photon counting systems deploy a large number of channels to achieve sufficient spatial resolution. Thus, the total power consumption might still produce a considerable amount of heat, requiring sophisticated cooling. Consequently, maximum power consumption per channel must be limited to allow for cost efficient air cooling.

As the sensor is usually not integrated in the CMOS frontend chip, a complex assembly process is required to connect sensor and frontend. As a result, there are external routing traces from the sensor to the frontend input which introduce an unneglectable amount of parasitic capacitance. As parasitic input capacitance directly impacts noise and speed of the CMOS frontend, this may considerably increase the integrated circuit's power consumption.

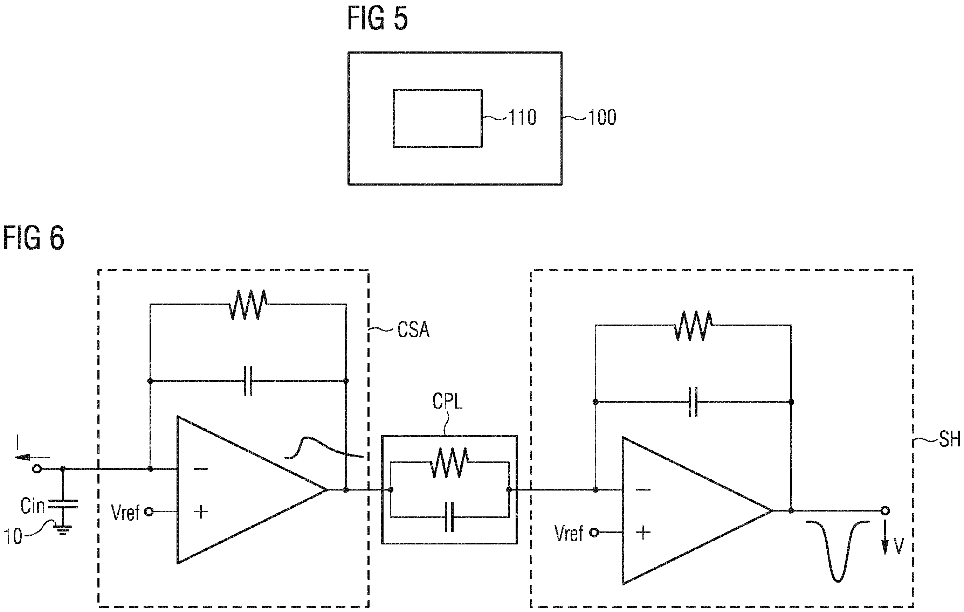

Two different topologies for photon counting frontends are employed in the state of the art. A first topology is depicted in Figure 6. This topology is based on a two-stage approach having a so-called charge sensitive amplifier, CSA, followed by a so-called shaper circuit SH which is mainly realized by another amplifier. The CSA receives current pulses from a sensor by input current I. A passive coupling network CPL added between both stages converts the CSA output voltage into a suitable shaper input current. The shaper SH therefrom provides an output voltage V containing voltage pulses.

The purpose of the CSA is to buffer the parasitic input capacitance Cin. It usually exhibits a large time constant, i.e. its output pulse response has a long decay time as shown in Figure 6 by the pulse at the output of the charge-sensitive amplifier CSA. The purpose of the shaper stage SH is to produce a sharp voltage pulse. Sharp pulses are desirable to minimize the pulse peaking time, in other words, the pulse should decay as fast as possible to allow processing of consecutive pulses after a short time in order to maximize count rate. As in this topology the large input capacitance Cin is buffered by the CSA, it is not seen by the shaper circuit SH which is beneficial for implementing short peaking times. However, this benefit is traded off against power consumption because two amplifiers are required.

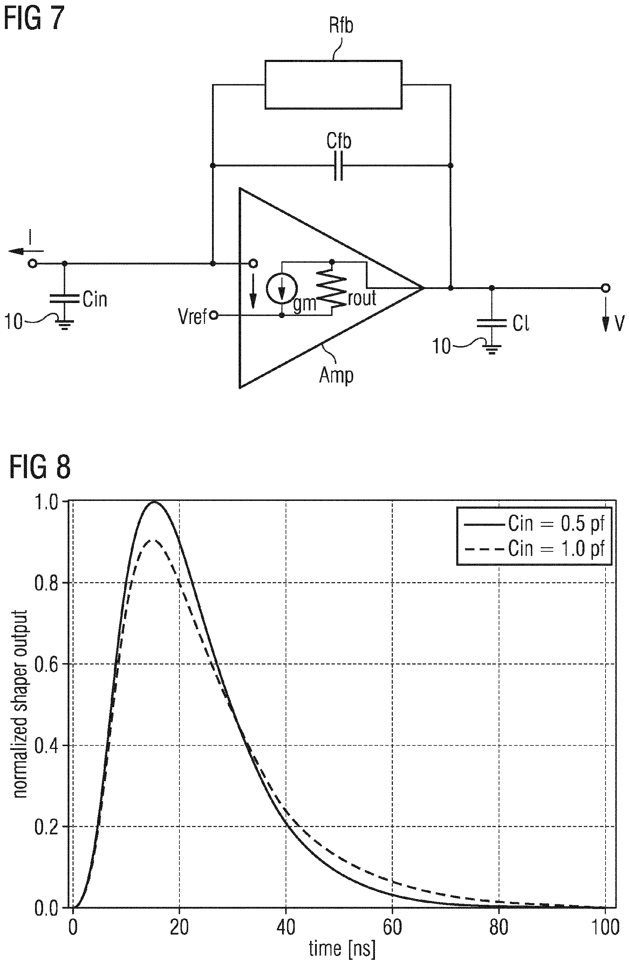

In a second known topology for a photon counting frontend, a single stage frontend topology is employed in case the corresponding assembly process achieves low input capacitance Cin. This topology is shown in Figure 7. It basically consists of an amplifier Amp with a feedback network consisting of a feedback capacitor Cfb and a feedback resistor Rfb connected in parallel. The CSA stage of Figure 6 is omitted. Pulses supplied with the sensor current I are directly converted into sharp output voltage pulses by the shaper amplifier Amp. This topology may only be used if the parasitic input capacitance Cin is small enough, for instance, in the range of 100 fF.

A current transfer function of the frontend circuit of Figure 7 including the parasitic input capacitance Cin and the load capacitance Cl can be approximated as

$$\frac{V}{I} \approx \frac{R_{fb}}{\frac{C_{in} \cdot C_L \cdot R_{fb}}{g_m} \cdot s^2 + C_{fb} \cdot R_{fb} \cdot s + 1} \quad (1).$$

Therein, V represents the output voltage V, I represents the sensor current I, $g_m$ represents a transconductance gm of the shaper amplifier Amp, s represents the complex frequency $j\omega$, $C_{fb}$ represents a capacitance of the feedback capacitor Cfb, $R_{fb}$ represents a resistance of the feedback resistor Rfb, $C_{in}$ represents the input capacitance Cin and $C_l$ represents the load capacitance Cl.

It can be seen that the input capacitance Cin and the load capacitance Cl introduce a higher order term. For attenuating said higher order term, the transconductance gm of the amplifier Amp could be increased. This, however, results in higher power consumption. Alternatively, the resistance value of the feedback resistor Rfb could be decreased. Unfortunately this leads to undershoot of the output signal V.

Figure 8 shows response curves of a single-stage frontend as of Figure 7 to a rectangular input current pulse provided with the sensor current I for varying values of the input capacitance Cin. The normalized shaper output with reference to time in nanoseconds is depicted. It can be inferred from the graph that with increasing input capacitance Cin, the frontend response slows down, i.e. the output pulse peaking time increases while the height of the pulse peak decreases.

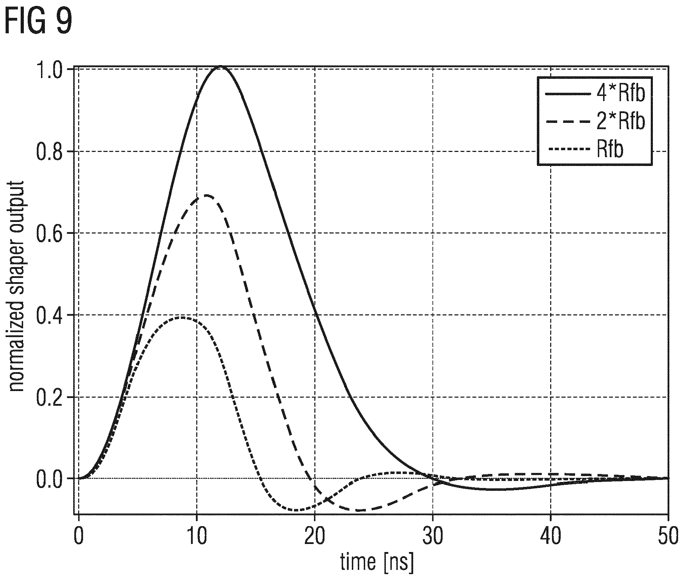

Figure 9 shows response curves of a single-stage frontend as of Figure 7 to a rectangular input current pulse provided with the sensor current I for varying values of the feedback resistor Rfb. The normalized shaper output is shown in relation to time in nanoseconds. It can be seen that reduction of the value of the feedback resistor Rfb leads to an undershoot or even to oscillations in the pulse response.

A loop transfer function of the frontend circuit of Figure 7 can be approximated as

$$A_{loop} \approx \frac{g_m r_{out} \cdot (1 + s \cdot C_{fb} \cdot R_{fb})}{(1 + s \cdot (C_{fb} + C_{in}) \cdot R_{fb}) \cdot (1 + s \cdot C_L \cdot r_{out})} \quad (2).$$

Therein, $A_{loop}$ represents a loop gain of the frontend of Figure 7, $r_{out}$ represents a resistance of an internal output resistor rout of the amplifier Amp, $g_m$ represents a transconductance gm of the shaper amplifier Amp, s represents the complex frequency $j\omega$, $C_{fb}$ represents a capacitance of the feedback capacitor Cfb, $R_{fb}$ represents a resistance of the feedback resistor Rfb, $C_{in}$ represents the input capacitance Cin and $C_l$ represents the load capacitance Cl.

Consequently, there are two poles p1, p2 and one zero z1:

$$p_1 = \frac{1}{(C_{fb} + C_{in}) \cdot R_{fb}} \quad (3)$$

$$p_2 = \frac{1}{C_L \cdot r_{out}} \quad (4)$$

$$z_1 = \frac{1}{C_{fb} \cdot R_{fb}} \quad (5).$$

The low frequency pole p1 mainly results from the feedback network of the amplifier Amp, while the high frequency pole p2 is mainly caused by the internal output resistor rout of the amplifier Amp. For a large output resistor rout or a small feedback resistor Rfb, which is desirable for attenuating the higher order term mentioned above, the zero z1 moves beyond the pole p2. The resulting arrangement of poles p1, p2 with zero z1 is shown in the following graph with relation to frequency f:

As a result, the transient response of the corresponding frontend of Figure 7 shows undershoots as in Figure 9.

It is therefore an objective to provide a shaper circuit, a photon counting circuit and an X-ray apparatus with improved performance compared with the prior art.

The objective is achieved by the subject matter of the independent claims. Further developments and embodiments are defined in dependent claims.

The definition of terms provided in the above also apply to the following description unless stated otherwise.

SUMMARY OF THE INVENTION

In one embodiment a shaper circuit comprises a first amplifier, a feedback component and an RC component. The first amplifier comprises an input and an output, the input being configured to receive an input signal, which comprises one or more current pulses. The feedback component is coupled to the output and to the input of the first amplifier, thereby forming a feedback loop of the first amplifier. The RC component is coupled to the output of the first amplifier and to a reference potential terminal. Therein the shaper circuit is configured to provide an output signal as a function of the input signal, the output signal comprising one or more voltage pulses. Therein, the RC component is configured to largely cancel a low frequency pole of the feedback loop of the amplifier.

The shaper circuit amplifies and converts current pulses received with the input signal into sharp voltage pulses, which are furnished with the output signal. By means of the RC component, a loop gain function, also called loop transfer function, of the shaper circuit is altered such that a low frequency pole caused by the feedback loop of the first amplifier is largely cancelled. Largely cancelled means that the influence of the low frequency pole is reduced to almost zero or zero. Consequently, overshoot, undershoot or oscillation of the output signal is prohibited. The single stage topology of the proposed shaper circuit results in power savings compared with state of the art two-stage topologies, e.g. as depicted in Figure 6. Furthermore, the proposed shaper circuit is able to cope with a large input capacitance. The single-stage shaper circuit as proposed is smaller in size which reduces chip size and manufacturing costs.

Each current pulse of the input signal may represent a quant. The shaper circuit may be used as the frontend in a photon counting system.

The feedback component may comprise a feedback capacitor and a feedback transconductance element which are connected in parallel to each other. The transconductance element may comprise an operational transconductance amplifier or a resistor. In the following the transconductance element is referred to as the feedback resistor.

In a development the RC component comprises a resistor and a capacitor which are connected in series. The resistor or the capacitor is directly connected to the output of the first amplifier.

The direct connection of the RC component to the output of the first amplifier implies that no other circuit elements are inserted between said output of the first amplifier and the RC component that would alter its pole cancellation capability in a significant way. Consequently, either the resistor of the RC component is directly connected to the output of the first amplifier and the capacitor of the RC component is connected with its first terminal to the resistor and connected to the reference potential terminal with its second terminal. Or, alternatively, the capacitor of the RC component is directly connected to the output of the first amplifier with its first terminal and the resistor is connected to the second terminal of the capacitor and connected to the reference potential terminal on the other side.

In a development a resistance of the resistor of the RC component is smaller than or equal to the resistance of an output resistor of the first amplifier.

The output resistor of the first amplifier represents the internal output resistor of the first amplifier.

In a further development a capacitance value of the capacitor of the RC component is larger than a load capacitance occurring at the output of the first amplifier.

The load capacitance occurring at the output of the first amplifier is the capacitance of the load connected downstream of the shaper circuit. Proper sizing of the resistor and the capacitor of the RC component as described above enables largely cancelling the low frequency pole p1 of the feedback loop of the amplifier. Whereas the pole p1 is cancelled, a new low frequency and dominant pole p3 is introduced as a side product of the RC network:

$$p_3 = \frac{1}{(C_l + C_z) \cdot r_{out}} \quad (6),$$

wherein, $p_3$ represents the pole p3, $r_{out}$ represents a resistance of the internal output resistor of the first amplifier, $C_z$ represents a capacitance of the capacitor of the RC component and $C_l$ represents the load capacitance.

At the same time, the high frequency pole p2 representing an output pole of the first amplifier is relocated to a higher frequency compared with the zero z1 which is mainly caused by the feedback component in the feedback loop of the first amplifier. In other words, the new high frequency pole p2' occurs at a higher frequency than the zero z1. This eliminates overshooting or undershooting or even oscillation of the output signal.

The resulting arrangement of poles p3, p2' with zero z1 is shown in the following graph with relation to frequency f:

Therein, the first amplifier is not configured as an integrator, it rather works as an amplifier for the charge provided with each current pulse of the input signal.

In another development the first amplifier comprises an operational transconductance amplifier. A transconductance value of said first amplifier is adjusted in dependence on an input capacitance occurring at the input of the shaper circuit.

The shaper circuit is operated in pulse mode, i.e. at high frequency corresponding to pulse widths down to a few nanoseconds. The input capacitance which is seen by the shaper circuit is highly dependent on routing traces from an external sensor which can be connected to the shaper circuit, for instance. An output of the shaper circuit which mainly coincides with the output of the first amplifier exhibits dependency on said input capacitance. The influence of the parasitic input capacitance is further compensated by adjusting the transconductance value of the first amplifier depending on said input capacitance. This can be concluded, for instance, during production of the circuit. Thereby, the transconductance value of the first amplifier is tuned with respect to a nominal design point of the shaper circuit.

The shaper circuit is consequently suitable also for large input capacitance. Improvement compared with the prior art is achieved in higher power savings caused by the single stage shaper circuit topology and applicability for large input capacitance.

In another development the shaper circuit further comprises a buffer component which is connected to the output of the first amplifier. The buffer component comprises a second amplifier having a unity gain or having a gain below ten.

The buffer component is connected directly to the output of the first amplifier in series to the first amplifier. In this development the output signal is provided at an output of the second amplifier.

Use of the buffer component enables the shaper circuit to drive a load having high capacitance of a few hundred fF, for example. By using the buffer component some of the gain drop resulting from reduction of the resistance of the feedback resistor in the feedback component as indicated above can be recovered, if the buffer component implements moderate gain of about 2. The buffer component isolates the output of the first amplifier from circuitry which is connected downstream of the shaper circuit and might have high capacitance.

In a development the second amplifier is configured as an open loop amplifier. The second amplifier comprises a first and a second metal oxide semiconductor, MOS, transistor of the same type. Said transistors are connected by their drain terminals and by their source terminals. Said source terminals are connected to the ground potential terminal. Therein, a gate terminal of the first transistor is connected to the output of the first amplifier. A gate terminal of a second transistor is connected to its drain terminal. The output signal is provided at the drain terminals of the first and the second transistor.

The type of a transistor may either be NMOS or PMOS.

A gain is calculated as the quotient of the transconductances of first and second transistors. The buffer component may consequently be realized, for example, by two differently sized or differently biased NMOS transistors. Process and temperature variation in transconductance of the first and second transistors is properly cancelled.

In another development which is alternative to the just described development, the second amplifier comprises a third MOS transistor, a fourth MOS transistor and a fifth MOS transistor that are all of the same type. The third and the fourth transistor are connected by their respective drain terminal. A gate terminal of the third transistor is connected to the output of the first amplifier. A gate terminal of the fourth transistor is connected to its drain terminal. A source terminal of the fourth transistor is connected to a source terminal of the fifth transistor. A gate terminal of the fifth transistor is prepared to receive a reference voltage. The output signal is provided at the drain terminals of third and fourth transistors.

In this development the fourth transistor representing the load transistor is biased via its source terminal using the fifth transistor. Consequently, variations in process, voltage or temperature in the load device, i.e. the fourth transistor, are compensated for and do not affect the output bias voltage of the amplifier. The output signal represents the inverted form of the output signal at the output of the first amplifier.

In another alternative development the second amplifier is configured as open loop amplifier and comprises a sixth MOS transistor, a seventh MOS transistor, an eighth MOS transistor and a ninth MOS transistor that are all of the same type. The sixth and the seventh transistor are connected by their respective source terminal. A gate terminal of the sixth transistor is connected to the output of the first amplifier. A drain terminal of the sixth transistor is connected to a drain terminal of the seventh transistor via a current mirror. A gate terminal of the seventh transistor is configured to receive a reference voltage. A drain terminal of the seventh transistor is connected to a drain terminal and a gate terminal of the eighth transistor. A source terminal of the eighth transistor is connected to a source terminal of the ninth transistor. A gate terminal of the ninth transistor is configured to receive the reference voltage. Therein the output signal is provided at the drain terminals of the seventh and the eighth transistor.

This development is a non-inverting version of the previously described development. It provides the output signal in a non-inverted form.

The reference voltage defines the output bias voltage of the second amplifier and thus should be dimensioned to maximize the second amplifier's output swing. For example, the reference voltage is set close to half of the sum of the maximum and the minimum of the output voltage where all transistors are still operating in saturation.

In a development the buffer component further comprises an RC divider circuit. The second amplifier is configured in feedback using the RC divider circuit.

By means of the buffer component, overshoot or undershoot of the output signal is further minimized.

In a further development the RC divider circuit comprises a first parallel connection comprising a first resistor and a first capacitor which are connected in parallel, and a second parallel connection having a second resistor and a second capacitor which are connected in parallel. The first parallel connection is coupled to an output of the second amplifier. The second parallel connection is connected in series to the first parallel connection and to the reference potential terminal. A connection point between the first and the second parallel connection is connected to an input of the second amplifier.

A quotient of a resistance of the first resistor and a resistance of the second resistor therein matches a quotient of a capacitance of the first capacitor and a capacitance of the second capacitor.

In a further development each of first and second resistors is implemented by a metal oxide semiconductor resistor comprising a tenth transistor, an eleventh transistor and a seventh current source. A gate terminal of the tenth transistor is connected to a gate terminal of the eleventh transistor. The gate terminal of the eleventh transistor is connected to a drain terminal of the eleventh transistor and to the current source. A source terminal of the eleventh transistor is connected to a supply potential terminal.

In some technologies resistors with high resistance are not feasible with low area. Therefore, using MOS transistors for the first and/or second resistor results in lower area consumption compared to using resistors.

Optionally, the MOS transistor further comprises a fourth capacitor. The optional capacitor is connected between the gate terminal and a source terminal of the tenth transistor in order to keep the MOS transistors gate-source voltage constant for AC signals. Thus, resistance modulation by the output signal is eliminated.

In one embodiment a photon counting circuit comprises a sensor, the shaper circuit as defined above, an analog-to-digital converter, ADC, and a counter component. The sensor is configured to detect one or more photons and convert each photon into a current pulse. The shaper circuit is connected to the sensor. The ADC is configured to receive the output signal of the shaper circuit and to provide a digital value for each of the received voltage pulses. Said digital value depends on the height of a converted voltage pulse. The counter component is coupled downstream of the ADC and is configured to count the digital values.

The sensor provides the current pulses which are fed to the input of the shaper circuit in the form of the input signal. The shaper circuit therefrom provides corresponding voltage pulses with the output signal. The ADC converts each voltage pulse into a digital value which is subsequently counted in the counter component.

Due to the realization of the shaper circuit as described above, the photon counting circuit can be realized with lower power consumption even in the case that a connection between sensor and shaper circuit results in a high input capacitance for the shaper circuit. Lower noise can be achieved by this solution. In addition the area of the implementation is reduced. This minimizes total die size, which leads to cost reduction.

A height of each voltage pulse of the output signal is proportional to the detected photon's energy, thus containing spectral information. Digitization of the pulses of the output signal, i.e. digitization of the spectral information is performed in the ADC. Said ADC may be implemented by using an asynchronously triggered Flash ADC, which consists of several comparators with different thresholds. The Flash ADC outputs are then individually counted in order to obtain a spectral distribution.

In one embodiment an X-ray apparatus uses the photon counting circuit as defined above.

The X-ray apparatus may also be realized as a computed tomography apparatus.

The photon counting circuit defined above may not only be used in medical imaging, but also in spectroscopy, security scanners and the like.

BRIEF DESCRIPTION OF THE DRAWINGS

The text below explains the proposed shaper circuit, photon counting circuit and X-ray apparatus in detail using exemplary embodiments with reference to the drawings. Components and circuit elements that are functionally identical or have the identical effect bear identical reference numbers. In so far as circuit parts or components correspond to one another in function, a description of them will not be repeated in each of the following figures. Therein,

Figure 1 shows a first exemplary embodiment of the proposed shaper circuit,

Figure 2 shows a second exemplary embodiment of the proposed shaper circuit,

Figures 3a, 3b, 3c and 3d each show an exemplary embodiment of a buffer component as proposed,

Figure 4 shows an exemplary embodiment of the proposed photon counting circuit, and

Figure 5 shows an exemplary embodiment of the proposed X-ray apparatus,

Figure 6 shows a two-stage photon counting frontend of the state of the art,

Figure 7 shows a single-stage photon counting frontend of the state of the art,

Figures 8 and 9 each show curves of the single-stage frontend of the state of the art according to Figure 7.

DETAILED DESCRIPTION

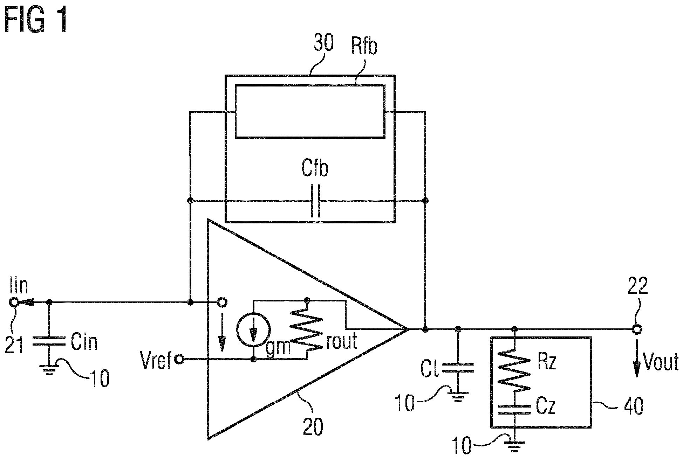

Figure 1 shows a first exemplary embodiment of the proposed shaper circuit.

The shaper circuit comprises a first amplifier 20, a feedback component 30 and an RC component 40. The first amplifier 20 comprises an input 21 and an output 22. The input 21 is configured to receive an input signal Iin, which comprises one or more current pulses. The feedback component 30 is coupled between the output 22 and the input 21 of the first amplifier 20. The RC component 40 is coupled to the output 22 of the first amplifier 20 and to a reference potential terminal 10. The shaper circuit is configured to provide an output signal Vout as a function of the input signal Iin. The output signal Vout comprises one or more voltage pulses. Therein, the RC component 40 is configured to largely cancel a low frequency pole of the feedback loop of the first amplifier 20.

In the embodiment depicted in Figure 1 the feedback component 30 comprises a transconductance element Rfb and feedback capacitor Cfb which are coupled in parallel. The transconductance element Rfb may be realized by a feedback resistor Rfb or by an operational transconductance amplifier.

The RC component 40 comprises a resistor Rz and a capacitor Cz which are coupled in series between the output 22 of the first amplifier 20 and the reference potential terminal. As depicted in Figure 1, the resistor Rz is directly connected to the output 22 of the first amplifier 20. A second terminal of the resistor Rz is coupled to a first terminal of the capacitor Cz. A second terminal of the capacitor Cz is connected to the reference potential terminal. In an alternative realization, not shown in Figure 1, the order of the capacitor Cz and the resistor Rz is reversed, i.e. the capacitor Cz is directly connected to the output 22 of the first amplifier 20 and the resistor Rz is connected to the second plate of the capacitor Cz and, on the other hand, is connected to the reference potential terminal.

In the depicted example the first amplifier 20 is realized as an operational transconductance amplifier 20 having an inverting input which coincides with the input 21 and a non-inverting input which receives a reference voltage Vref. The depicted exemplary embodiment also shows the parasitic input capacitance represented by input capacitor Cin which is coupled to the input 21 and to the reference potential terminal 10. Furthermore, a load capacitance which occurs at the output 22 is depicted and represented by a load capacitor Cl, which is connected to the output 22 and to the reference potential terminal 10.

The reference potential terminal 10 may be a ground potential terminal or a terminal supplied with a defined reference voltage.

The shaper circuit converts the current pulses received with the input signal Iin into voltage pulses, which are furnished with the output signal Vout. By means of the RC component 40, a loop gain function or a loop transfer function of the shaper circuit is altered such that a low frequency pole of the feedback loop of the amplifier is largely cancelled. Consequently, overshoot, undershoot or oscillation of the output signal Vout is prevented. This depicted single stage topology of the shaper circuit results in power savings compared with state of the art two-stage topologies.

A loop gain of the shaper circuit as proposed can be approximated according to the following equation:

$$A_{loop} \approx \frac{g_m r_{out} \cdot (1 + s \cdot C_{fb} \cdot R_{fb}) \cdot (1 + s \cdot C_z \cdot R_z)}{(1 + s \cdot (C_{fb} + C_{in}) \cdot R_{fb}) \cdot (1 + s \cdot (C_L + C_z) \cdot r_{out}) \cdot (1 + s \cdot C_L \cdot R_z || rout)} \quad (7).$$

Therein $A_{loop}$ represents a loop gain of the frontend of Figure 1, $r_{out}$ represents a resistance of the internal output resistor rout of the first amplifier 20, $g_m$ represents a transconductance gm of the first amplifier 20, s represents the complex frequency $j\omega$, $C_{fb}$ represents a capacitance of the feedback capacitor Cfb, $R_{fb}$ represents a resistance of the feedback resistor Rfb, $C_{in}$ represents the input capacitance Cin and $C_l$ represents the load capacitance Cl, $C_z$ represents the capacitance value of the capacitor Cz of the RC component, $R_z$ represents the resistance value of the resistor Rz of the RC component 40.

By means of the RC component 40, a low frequency pole p1 of the loop gain function as defined in equation (3) is largely cancelled.

A resistance of the resistor Rz of the RC component 40 is smaller than or equal to a resistance of the internal output resistor rout of the first amplifier 20. Furthermore, a capacitance value of the capacitor Cz of the RC component 40 is larger than a load capacitance Cl at the output 22 of the first amplifier.

Due to cancelling of the low frequency pole p1, the loop gain $A_{loop}$ of the shaper circuit is approximated by the following equation

$$A_{loop} \approx \frac{g_m r_{out} \cdot (1 + s \cdot C_{fb} \cdot R_{fb})}{(1 + s \cdot (C_L + C_z) \cdot r_{out}) \cdot (1 + s \cdot C_L \cdot R_z || r_{out})} \quad (8).$$

Furthermore, the introduction of the RC component 40 and proper dimensioning of the resistor Rz and the capacitor Cz of said RC component 40 achieves that the high frequency pole p2' is moved to higher frequencies beyond the zero z1 as detailed in the following graph:

The high frequency pole p2' results from the parallel connection of the internal output resistor rout of the first amplifier 20 and the resistor Rz of the RC component 40. Another zero z2 is introduced by the RC component 40 as well as another pole p3 as indicated in the graph and already described above.

Compared with state of the art single stage topologies as depicted in Figure 7, for example, the shaper circuit as proposed is able to cope with large input capacitance Cin of up to 1pF, for example, without overshoot or undershoot of the output signal Vout.

The RC component 40 may also be denoted as a pole zero network, because it largely cancels the low frequency pole p1 and moves the high frequency pole p2' to higher frequencies beyond the zero z1. At high frequencies, the capacitor Cz acts as a short, leaving the resistor Rz in parallel to the internal output resistor of the first amplifier, effectively shifting the high frequency pole p2 to the right beyond z1.

For further improving the proposed shaper circuit's performance, a transconductance value gm of the first amplifier 20 is adjusted in dependence on the input capacitance Cin. Thereby, compensation is achieved for varying input capacitance Cin. As explained above, the input capacitance is highly dependent on package routing. Therefore, by calibrating the transconductance value gm of the first amplifier 20, the influence of the input capacitance Cin is further reduced.

The transconductance gm of the first amplifier 20 is tuned with respect to a nominal design point in dependence on the input capacitance Cin, a nominal input capacitance Cin0 and a nominal transconductance gm0 according to the following equation:

$$gm = \frac{Cin}{Cin0} * gm0 \quad (9).$$

Therein, gm represents the transconductance gm of the first amplifier 20, gm0 represents the nominal transconductance gm0 of the first amplifier 20, Cin represents the input capacitance Cin occurring at the input 21 of the shaper circuit and Cin0 represents the nominal input capacitance Cin0.

Consequently, by calibrating out the influence of the input capacitance, constant performance of the shaper circuit even in the presence of varying input capacitance Cin is guaranteed.

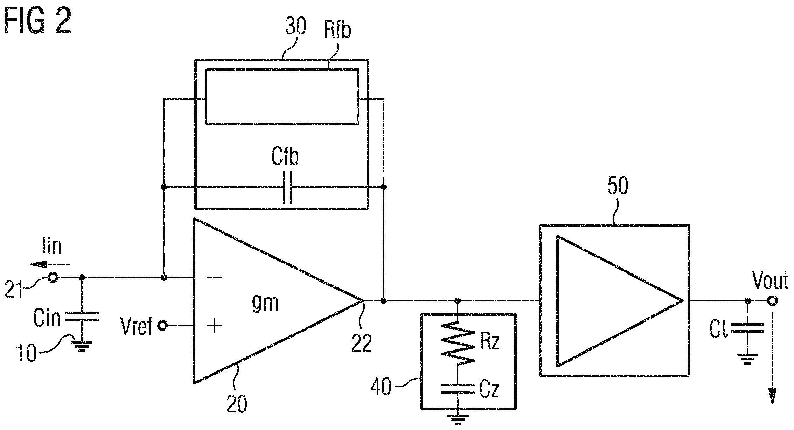

Figure 2 shows a second exemplary embodiment of the shaper circuit as proposed. The shaper circuit depicted in Figure 2 coincides with the shaper circuit of Figure 1 and additionally comprises a buffer component 50. Said buffer component 50 is connected to the output 22 of the first amplifier 20. The buffer component 50 comprises a second amplifier 51 having unity gain or having a gain below 10. In this exemplary embodiment the output signal Vout is provided at an output of the buffer component 50.

By means of the buffer component 50 the output 22 of the shaper circuit is isolated from subsequent circuitry which can be connected to said output and may have considerable capacitive load of several hundred nF represented by the load capacitor Cl. The second operational amplifier 51 of the buffer component 50 is configured as an open loop circuit in order to keep power consumption by the buffer component 50 as low as possible. A gain of the second amplifier 51 is chosen to be below 10. In the depicted example the gain is below 2 or is a unity gain.

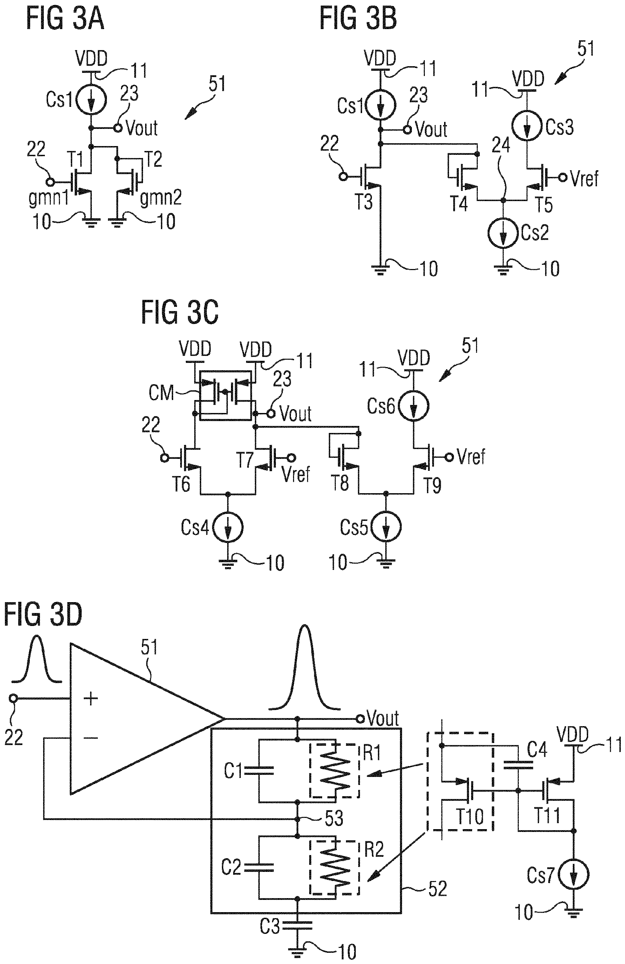

In the following figures 3A, 3B, 3C and 3D different implementation possibilities for the buffer component are

EP 3 975 423 A1

depicted and explained in detail in exemplary embodiments.

Figure 3A shows a first exemplary embodiment of a buffer component as proposed. In this embodiment the buffer component comprises the operational amplifier 51 which comprises a first transistor T1 and a second transistor T2. The first and second transistors T1, T2 are respectively realized as a MOS transistor of the same type, i.e. both transistors are realized as NMOS transistors as depicted in Figure 3A. The first and second transistors T1, T2 are connected by their drain terminals 23 and are also connected by their source terminals. The source terminals of transistors T1 and T2 are also connected to the reference potential terminal 10. A gate terminal of the first transistor T1 is connected to the output 22 of the first amplifier 20. A gate terminal of the second transistor T2 is connected to its drain terminal 23. Said drain terminal 23 is also connected via a first current source Cs1 to a supply potential terminal 11. The supply potential terminal 11 receives a supply voltage Vdd, for example. The output signal Vout is provided at the drain terminals 23 of the first and the second transistor T1, T2.

The first transistor T1 has a first transconductance gm1, while the second transistor T2 has a second transconductance gm2. A gain realized by the example embodiment of Figure 3A can be calculated as the quotient of the first transconductance gm1 with the second transconductance gm2. The second transistor T2 therein forms a load transistor to the first transistor T1.

Figure 3B shows a second exemplary embodiment of the proposed buffer component. In this embodiment the second amplifier 51 comprises a third, a fourth and a fifth transistor T3, T4, T5, which are all realized as MOS transistors of the same type. Third and fourth transistors T3, T4 are connected by their drain terminals 23. A gate terminal of the third transistor T3 is connected to the output 22 of the first amplifier 20. A gate terminal of the fourth transistor T4 is connected to its drain terminal 23. A source terminal of the fourth transistor T4 is connected to a source terminal of the fifth transistor T5. A gate terminal of the fifth transistor is prepared to receive a reference voltage Vref. Respective source terminals 24 of the fourth and the fifth transistor T4, T5 are connected via a second current source Cs2 to the reference potential terminal 10. A drain terminal of the fifth transistor is connected via a third current source Cs3 to the supply potential terminal 11. The drain terminal of the third transistor T3 is coupled by the first current source Cs1 to the supply potential terminal 11. The output signal Vout is provided at the drain terminals 23 of the third and fourth transistors T3, T4.

In this exemplary embodiment the fourth transistor T4 representing the load to the third transistor T3 is biased via its source terminal 24 using the fifth transistor T5. Thereby, process, voltage, and temperature variations, PVT variations, of the fourth transistor T4 are compensated. The output signal Vout becomes independent of PVT variations.

The exemplary embodiment of Figure 3B realizes an inverting buffer component, i.e. the output signal Vout is provided in its inverted form.

Figure 3C shows a third exemplary embodiment of the buffer component. It comprises a sixth, a seventh, an eighth and a ninth transistor T6, T7, T8, T9 which are all realized as MOS transistors of the same type, here NMOS. The sixth and seventh transistors T6, T7 are connected by their source terminals. Said source terminals are coupled to the reference potential terminal 10 via a fourth current source Cs4. A gate terminal of the sixth transistor T6 is connected to the output 22 of the first amplifier 20. A drain terminal of the sixth transistor T6 is connected to a drain terminal of the seventh transistor T7 via a current mirror CM. A gate terminal of the seventh transistor T7 is prepared to receive the reference voltage Vref. A drain terminal 23 of the seventh transistor T7 is connected to a gate and a drain terminal of the eighth transistor T8. A source terminal of the eighth transistor T8 is connected to a source terminal of the ninth transistor T9. Said source terminals are further connected via a fifth current source Cs5 to the reference potential terminal 10. A gate terminal of the ninth transistor T9 is prepared to receive the reference voltage Vref. A drain terminal of the ninth transistor T9 is connected via a sixth current source Cs6 to the supply potential terminal 11. The output signal Vout is provided at the drain terminals 23 of the seventh and the eighth transistor T7, T8.

The sixth transistor T6 represents the input device of the second amplifier, while the eighth transistor T8 forms the output device. As the transistors T6 and T8 experience the same swing in their respective gate-source voltages and the same large signal operating point, nonlinearity is cancelled in this embodiment.

Regarding the dimensions of the current sources it is to be considered that first and fourth current source Cs1 and Cs4 determine the speed of the buffer component. So, the current is set high enough not to distort the waveform at the output of the first amplifier 20. The required current will be dependent on the load capacitance of the buffer component. The second, third, fifth and sixth current source Cs2, Cs3, Cs5 and Cs6 are dimensioned with respect the first and fourth current source Cs1 and Cs4 because they determine the transconductance gm2. Therefore, the currents provided by the current sources will be adjusted to provide the required voltage gain, i.e the ratio or quotient of the first transconductance gm1 and the second transconductance gm2.

Figure 3D shows a fourth exemplary embodiment of a buffer component 50 as proposed. In the depicted embodiment the buffer component 50 comprises the second amplifier 51 and an RC divider 52. The second amplifier 51 is configured in feedback using the RC divider circuit 52. The RC divider circuit 52 comprises a first parallel connection having a first resistor R1 and a first capacitor C1 which are connected in parallel, and a second parallel connection having a second resistor R2 and a second capacitor C2, which are connected in parallel. The first parallel connection R1, C1 is coupled to an output of the second amplifier 51. The second parallel connection R2, C2 is connected in series to the first parallel connection R1, C1 and to the reference potential terminal 10. A connection point 53 between the first and the second parallel connection is connected to an input of the second amplifier 51. Optionally, the buffer component 50 in this embodiment also comprises a third capacitor C3 which is coupled between the reference potential terminal 10 and the RC divider circuit 52. The connection point 53 is, for instance, coupled to an inverting input of the second amplifier 51, while the non-inverting input of the second amplifier 51 is directly connected to the output 22 of the first amplifier 20.

The circuit elements of the RC divider circuit 52 are dimensioned to fulfil the following equation:

$$\frac{R1}{R2} = \frac{C2}{C1} \quad (10).$$

Therein, R1 represents the resistance of the first resistor R1, R2 represents the resistance of the second resistor R2, C1 represents the capacitance of the first capacitor C1 and C2 represents the capacitance of the second capacitor C2.
The depicted realization of the buffer component 50 achieves the following gain in dependency of the complex frequency $j\omega$:

$$A(j\omega) \approx 1 + \frac{R1 || \frac{1}{j\omega C1}}{R2 || \frac{1}{j\omega C2}} \quad (11).$$

Therein, $j\omega$ represents the complex frequency $j\omega$, R1 represents the resistance of the first resistor R1, R2 represents the resistance of the second resistor R2, C1 represents the capacitance of the first capacitor C1, C2 represents the capacitance of the second capacitor C2 and $||$ refers to the parallel connection of resistor R1 and capacitor C1, or of the resistor R2 and capacitor C2, respectively.
As can be seen, frequency dependency is further reduced.
As indicated on the side of Figure 3D, each of first and second resistors R1, R2 may be implemented by a MOS resistor. Said MOS resistor comprises a tenth transistor T10, an eleventh transistor T11, a fourth capacitor C4 and a seventh current source Cs7. A gate terminal of the tenth transistor T10 is connected to a gate terminal of the eleventh transistor T11. The fourth capacitor C4 is connected between the gate terminal and a source terminal of the tenth transistor T10. The gate terminal of the eleventh transistor T11 is connected to a drain terminal of the eleventh transistor T11 and to the seventh current source Cs7. Said current source Cs7 is connected to the reference potential terminal 10 on the other side. A source terminal of the eleventh transistor T11 is connected to the supply potential terminal 11. The AC coupling implemented by the fourth capacitor C4 achieves that a gate-source voltage of the tenth transistor T10 remains mainly constant which minimizes overdrive variation.

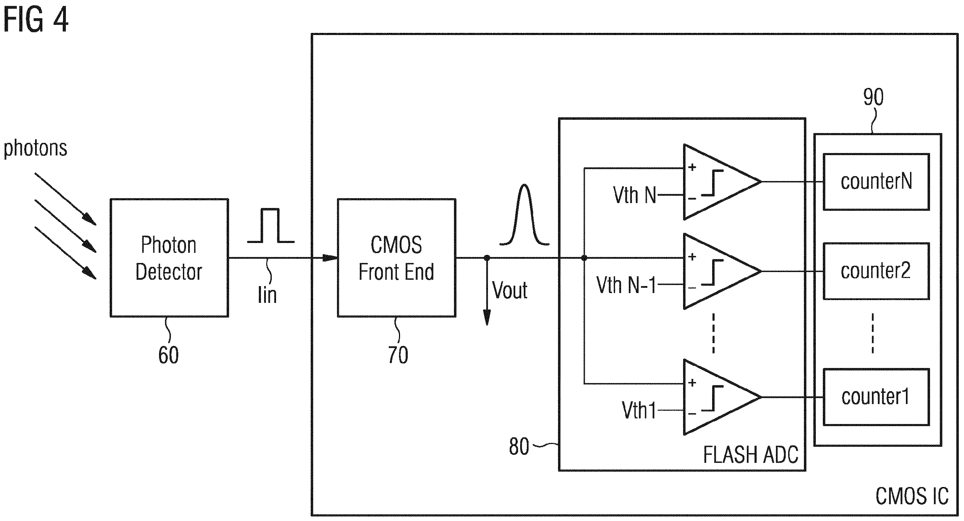

Figure 4 shows an exemplary embodiment of the proposed photon counting circuit. The photon counting circuit comprises a sensor 60 configured to detect one or more photons and to convert each photon into a current pulse. The photon counting circuit further comprises the shaper circuit 20 which conforms to the shaper circuit according to one of the embodiments described above, an analog-to-digital converter, ADC, 80 and a counter component 90. The shaper circuit 70 is connected to an output of the sensor 60 and receives the input signal Iin from the sensor 60. The ADC 80 is configured to receive the output signal Vout of the shaper circuit 70 and to provide a digital value for each of the received voltage pulses. The digital value thereby depends on the height of a converted voltage pulse. The counter component 90 is coupled downstream of the ADC 80. The counter component 90 is configured to count the digital values.
The ADC 80 may be realized by an asynchronously flash ADC comprising a number of comparators as indicated in Figure 4. The counter component 90 may comprise a number of counters as indicated in Figure 4, the number of counters matching the number of comparators of the flash ADC. In an implementation example, the shaper circuit 70, the ADC 80 and the counter component 90 are realized as an integrated circuit, for example as a complementary MOS, CMOS, integrated circuit. The sensor 60 is connected to said integrated circuit. Due to the realization of the shaper circuit 70 as described above, the influence of external routing traces from the sensor to the shaper circuit 70, especially its parasitic capacitance is greatly reduced. The shaper circuit 70 may also be designated as a CMOS frontend, or as an analog frontend for photon counting. As the shaper circuit 70 generates sharp voltage pulses which are provided with the output signal Vout to the ADC 80, performance of the integrated circuit is greatly improved compared with state of the art implementations.
Figure 5 shows an exemplary embodiment of an X-ray apparatus as proposed. The X-ray apparatus 100 comprises at least one photon counting circuit 110 which complies with the photon counting circuit as described above. By using the photon counting circuit as proposed in this application, the X-ray apparatus is enabled to provide pictures with higher quality.

The X-ray apparatus may also be realized as a computed tomography apparatus.

It will be appreciated that the disclosure is not limited to the disclosed embodiments and to what has been particularly shown and described hereinabove. Rather, features recited in separate dependent claims or in the description may advantageously be combined. Furthermore, the scope of the disclosure includes those variations and modifications, which will be apparent to those skilled in the art. The term "comprising", insofar it was used in the claims or in the description, does not exclude other elements or steps of a corresponding feature or procedure. In case that the terms "a" or "an" were used in conjunction with features, they do not exclude a plurality of such features. Moreover, any reference signs in the claims should not be construed as limiting the scope.

Reference list

| | |
|---|---|
| 10, 11, 23 | terminal |
| 20, 51 | amplifier |
| 30 | feedback component |
| 40 | RC component |
| 50 | buffer component |
| 52 | divider circuit |
| 53 | connection point |
| 60 | sensor |
| 70 | shaper circuit |
| 80 | analog-to-digital converter |
| 90 | counter component |
| 100 | X-ray apparatus |
| 110 | photon counting circuit |
| 21 | input |
| 22 | output |
| Iin, Vout | signal |
| Cz, C1, C2, C3, C4, Cfb | capacitor |
| Cl, Cin | capacitance |
| Rz, R1, R2, Rfb | resistor |
| T1, T2, T3, T4, T5, T6, T7 | transistor |
| T8, T9, T10, T11 | transistor |
| Vref, VDD, V | voltage |
| 23 | terminal |
| CM | current mirror |
| Cs1, Cs2, Cs3, Cs4, Cs5 | current source |
| Cs6, Cs7 | current source |
| CPL | passive coupling network |
| CSA | charge sensitive amplifier |
| SH | shaper circuit |
| I | sensor current |

**Claims**

1. Shaper circuit comprising

- a first amplifier (20) comprising an input (21) and an output (22), the input (21) being configured to receive an input signal (Iin), which comprises one or more current pulses,
- a feedback component (30) coupled to the output (22) and to the input (21) of the first amplifier (20) thereby forming a feedback loop of the first amplifier (20), and
- an RC component (40) coupled to the output (22) of the first amplifier (20) and to a reference potential terminal (10),
- wherein the shaper circuit is configured to provide an output signal (Vout) as a function of the input signal (Iin), the output signal (Vout) comprising one or more voltage pulses,

- wherein the RC component (40) is configured to largely cancel a low frequency pole of the feedback loop of the first amplifier (20).

2. Shaper circuit according to claim 1,
   wherein the RC component (40) comprises a resistor (Rz) and a capacitor (Cz) which are connected in series, the resistor (Rz) or the capacitor (Cz) being directly connected to the output (22) of the first amplifier (20).

3. Shaper circuit according to claim 2,
   wherein a resistance of the resistor (Rz) of the RC component (40) is smaller than or equal to a resistance of an internal output resistor of the first amplifier (20).

4. Shaper circuit according to claim 2 or 3,
   wherein a capacitance of the capacitor (Cz) of the RC component (40) is larger than a load capacitance (Cl) occurring at the output (22) of the first amplifier (20).

5. Shaper circuit according to any of claims 1 to 4,
   wherein the first amplifier (20) comprises an operational transconductance amplifier and a transconductance of said first amplifier (20) is adjusted in dependence on an input capacitance (Cin) occurring at the input (21) of the shaper circuit.

6. Shaper circuit according to any of claims 1 to 5,
   further comprising a buffer component (50) which is connected to the output (22) of the first amplifier (20), the buffer component (50) comprising a second amplifier (51) having unity gain or having a gain below ten.

7. Shaper circuit according to claim 6,
   wherein the second amplifier (51) and is configured as open loop amplifier and comprises a first and a second metal-oxide semiconductor, MOS, transistor (T1, T2) of the same type, said transistors (T1, T2) being connected by their drain terminals (23) and by their source terminals which source terminals are connected to the ground potential terminal (10), wherein a gate terminal of the first transistor (T1) is connected to the output (22) of the first amplifier (20), a gate terminal of the second transistor (T2) is connected to its drain terminal (23) and wherein the output signal (Vout) is provided at the respective drain terminal (23) of the first and the second transistor (T1, T2).

8. Shaper circuit according to claim 6,
   wherein the second amplifier (51) is configured as open loop amplifier and comprises a third metal-oxide semiconductor, MOS, transistor, a fourth MOS transistor and a fifth MOS transistor (T3, T4, T5) that are all of the same type, the third and the fourth transistor (T3, T4) being connected by their respective drain terminal (23), wherein a gate terminal of the third transistor (T3) is connected to the output (22) of the first amplifier (20), a gate terminal of the fourth transistor (T4) is connected to its drain terminal (23), a source terminal (24) of the fourth transistor (T4) is connected to a source terminal of the fifth transistor (T5), a gate terminal of the fifth transistor (T5) is configured to receive a reference voltage (Vref) and wherein the output signal (Vout) is provided at the respective drain terminal (23) of the third and the fourth transistor (T3, T4).

9. Shaper circuit according to claim 6,
   wherein the second amplifier (51) is configured as open loop amplifier and comprises a sixth metal-oxide semiconductor, MOS, a seventh MOS transistor, an eighth MOS transistor and a ninth MOS transistor (T6, T7, T8, T9) that are all of the same type, the sixth and the seventh transistor (T6, T7) being connected by their respective source terminal, wherein a gate terminal of the sixth transistor (T6) is connected to the output (22) of the first amplifier (20), a drain terminal of the sixth transistor (T6) is connected to a drain terminal of the seventh transistor (T7) via a current mirror (CM), a gate terminal of the seventh transistor (T7) is configured to receive a reference voltage (Vref), a drain terminal of the seventh transistor (T7) is connected to a drain terminal and to a gate terminal of the eighth transistor (T8), a source terminal of the eighth transistor (T8) is connected to a source terminal of the ninth transistor (T9), a gate terminal of the ninth transistor (T9) is configured to receive the reference voltage (Vref), and wherein the output signal (Vout) is provided at the respective drain terminal (23) of the seventh and the eighth transistor (T7, T8).

10. Shaper circuit according to claim 6,
    wherein the buffer component (50) further comprises an RC divider circuit (52) and the second amplifier (51) is configured in feedback using the RC divider circuit (52).

**11.** Shaper circuit according to claim 10,
wherein the RC divider circuit (52) comprises a first parallel connection comprising a first resistor (R1) and a first capacitor (C1) being connected in parallel and a second parallel connection comprising a second resistor (R2) and a second capacitor (C2) being connected in parallel, wherein the first parallel connection is coupled to an output of the second amplifier (51), the second parallel connection is connected in series to the first parallel connection and to the reference potential terminal (10) and wherein a connection point (53) between the first and the second parallel connection is connected to an input of the second amplifier (51).

**12.** Shaper circuit according to claim 11,
wherein each of the first and the second resistor (R1, R2) is implemented by a Metal-oxide semiconductor resistor comprising a tenth transistor (T10), an eleventh transistor (T11) and a seventh current source (Cs7), wherein a gate terminal of the tenth transistor (T10) is connected to a gate terminal of the eleventh transistor (T11), the gate terminal of the eleventh transistor (T11) is connected to a drain terminal of the eleventh transistor (T11) and to seventh the current source (Cs7) and a source terminal of the eleventh transistor (T11) is connected to a supply potential terminal (11).

**13.** Photon counting circuit comprising
a sensor (60) configured to detect one or more photons and convert each photon into a current pulse,
the shaper circuit (70) according to one of claims 1 to 12, being connected to the sensor (70),
an analog-to-digital converter (80) configured to receive the output signal (Vout) of the shaper circuit (70) and to provide a digital value for each of the received voltage pulses, the digital value depending on the height of a converted voltage pulse, and
a counter component (90) coupled downstream of the analog-to-digital converter (80), the counter component (90) being configured to count the digital values.

**14.** X-ray apparatus using the photon counting circuit according to claim 13.

# FIG 1

FIG 2

EP 3 975 423 A1

## FIG 3A

## FIG 3B

## FIG 3C

## FIG 3D

FIG 4

# FIG 5

# FIG 6

EP 3 975 423 A1

## FIG 7

## FIG 8

# FIG 9

Europäisches
Patentamt

European
Patent Office

Office européen
des brevets

# EUROPEAN SEARCH REPORT

Application Number

EP 20 19 8994

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2014/332670 A1 (TATEIWA YOSHIHIRO [JP]) 13 November 2014 (2014-11-13) * paragraph [0040] - paragraph [0047]; figures 5,6 * | 1-14 | INV. H03F1/08 H03F3/08 H03F3/45 H03F3/70 H03F3/72 H03G5/12 H03F1/42 |
| A | US 2016/299002 A1 (STEADMAN BOOKER ROGER [DE] ET AL) 13 October 2016 (2016-10-13) * paragraph [0011] - paragraph [0015] * * paragraph [0042] - paragraph [0052]; figure 2A * | 13,14 | |
| A | US 2018/372887 A1 (GOEDERER EDGAR [DE] ET AL) 27 December 2018 (2018-12-27) * paragraphs [0005], [0016] * * paragraph [0101] - paragraph [0126]; figures 1,2 * | 13,14 | |
| A | US 5 864 416 A (WILLIAMS STEPHEN G [US]) 26 January 1999 (1999-01-26) * column 1, line 9 - line 18 * * column 2, line 31 - column 4, line 41; figure 1 * | 5 | |

TECHNICAL FIELDS SEARCHED (IPC)

H03F
H03G

The present search report has been drawn up for all claims

| Place of search | Date of completion of the search | Examiner |
|---|---|---|
| The Hague | 12 March 2021 | Wienema, David |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 20 19 8994

This annex lists the patent family members relating to the patent documents cited in the above-mentioned European search report.
The members are as contained in the European Patent Office EDP file on
The European Patent Office is in no way liable for these particulars which are merely given for the purpose of information.

12-03-2021

| Patent document cited in search report | | | Publication date | Patent family member(s) | | | Publication date |
|---|---|---|---|---|---|---|---|
| US 2014332670 | A1 | | 13-11-2014 | JP | 2014220748 | A | 20-11-2014 |
| | | | | US | 2014332670 | A1 | 13-11-2014 |
| US 2016299002 | A1 | | 13-10-2016 | CN | 105765405 | A | 13-07-2016 |
| | | | | EP | 3074789 | A1 | 05-10-2016 |
| | | | | JP | 6434022 | B2 | 05-12-2018 |
| | | | | JP | 2016540209 | A | 22-12-2016 |
| | | | | US | 2016299002 | A1 | 13-10-2016 |
| | | | | WO | 2015078681 | A1 | 04-06-2015 |
| US 2018372887 | A1 | | 27-12-2018 | CN | 109100771 | A | 28-12-2018 |
| | | | | EP | 3418776 | A1 | 26-12-2018 |
| | | | | US | 2018372887 | A1 | 27-12-2018 |
| US 5864416 | A | | 26-01-1999 | NONE | | | |

EPO FORM P0459

For more details about this annex : see Official Journal of the European Patent Office, No. 12/82